# EUROPEAN PATENT APPLICATION

(11) **EP 4 679 944 A1**
(43) Date of publication of application: **14.01.2026**
(21) Application number: 24769911.9
(22) Date of filing: 11.03.2024
(51) Int. Cl.: H05K 1/11, H05K 1/02

(54) **PRINTED CIRCUIT BOARD, POWER MODULE, AND ELECTRONIC DEVICE**

(30) Priority: 13.03.2023 CN 202310274058
(71) Applicant: ZTE Corporation, Shenzhen, Guangdong 518057 (CN)
(72) Inventor: LU, Xian, Shenzhen, Guangdong 518057 (CN)
(74) Representative: Ziebig Hengelhaupt Intellectual Property Attorneys Patentanwaltskanzlei PartGmbB
(86) International application number: PCT/CN2024/081014
(87) International publication number: WO 2024/188218

(57) **Abstract**

The present application discloses a printed circuit board, a power module and an electronic device. The printed circuit board includes: a surface power layer having a first power region for soldering a pin of the chip; and a first current flow bridge provided at the surface power layer and electrically connected to the first power region. The first current flow bridge covers the first power region and extends to outside of the first power region. The present application provides a printed circuit board, a power module and an electronic device.

## Description

### CROSS-REFERENCE TO RELATED APPLICATIONS

The present application claims priority to Chinese Patent Application No. 202310274058.4, filed on March 13, 2023, the entire contents of which are incorporated herein by reference.

### TECHNICAL FIELD

The present application relates to the technical field of circuit board flow, and in particular to a printed circuit board (PCB), a power module and an electronic device.

### BACKGROUND

With the development of cloud computing applications, information technology is gradually permeating all areas of society. People's daily work and life increasingly rely on the Internet for communication, and the amount of network data is constantly increasing, placing higher performance demands on servers. As the operating speed of the server systems increases, the operating voltage becomes lower and the operating current becomes larger. Therefore, PCB power supplies are becoming increasingly important in the design of high-speed systems. Currently, In the design of a PCB power module, power is typically supplied and transmitted through copper conductors. To improve the current flow capacity of the power module, one approach is to increase the number of PCB layers. However, this approach increases the overall thickness of the PCB, affecting the power supply efficiency.

### SUMMARY

The main purpose of the present application is to provide a printed circuit board, a power module and an electronic device, aiming to address the technical problem that the existing circuit boards is not conducive to high-current power supply.

To achieve the above purpose, embodiments of the present application provide a printed circuit board for soldering a chip, including: a surface power layer and a first current flow bridge. The surface power layer has a first power region, and the first power region is configured for soldering a pin of the chip. The first current flow bridge is provided at the surface power layer and electrically connected to the first power region, and the first current flow bridge covers the first power region and extends to outside of the first power region.

To achieve the above purpose, embodiments of the present application provide a power module, including: the printed circuit board as described above, a chip provided in a first power region, and a power supply module provided on one side of the chip. A first current flow bridge extends to the power supply module.

To achieve the above purpose, embodiments of the present application provide an electronic device, including the power module as described above.

### BRIEF DESCRIPTION OF THE DRAWINGS

To more clearly illustrate the technical solutions in the embodiments of the present application or in the related art, accompanying drawings required for the description of the embodiments or the related art will be described briefly below. Obviously, the accompanying drawings described below are only some embodiments of the present application. For those skilled in the art, other drawings can also be obtained based on the structures shown in these drawings without inventive effort.
FIG. 1 is an exploded structural schematic diagram of a printed circuit board according to an embodiment of the present application.
FIG. 2 is a first schematic structural diagram of a surface power layer of the printed circuit board according to an embodiment of the present application.
FIG. 3 is a second schematic structural diagram of the surface power layer of the printed circuit board according to an embodiment of the present application.
FIG. 4 is a first schematic structural diagram of an inner signal layer of the printed circuit board according to an embodiment of the present application.
FIG. 5 is a second schematic structural diagram of the inner signal layer of the printed circuit board according to an embodiment of the present application.
FIG. 6 is a third schematic structural diagram of the inner signal layer of the printed circuit board according to an embodiment of the present application.
FIG. 7 is a fourth schematic structural diagram of the inner signal layer of the printed circuit board according to an embodiment of the present application.
FIG. 8 is a first schematic structural diagram of a pin layout of a chip in the printed circuit board according to an embodiment of the present application.
FIG. 9 is a second schematic structural diagram of the pin layout of the chip in the printed circuit board according to an embodiment of the present application.

Description of Reference Signs:

| reference sign | name | reference sign | name |
|---|---|---|---|
| 10 | surface power layer | 20 | first current flow bridge |
| 30 | current flow block | 40 | inner signal layer |
| 50 | second current flow bridge | 60 | chip |
| 61 | pin | 70 | power supply module |

The realization of the objectives, functional features and advantages of the present application will be further explained in conjunction with embodiments and with reference to the accompanying drawings.

### DETAILED DESCRIPTION OF THE EMBODIMENTS

The technical solutions in the embodiments of the present application will be described clearly and completely below with reference to the accompanying drawings. Obviously, the described embodiments are only some rather than all of the embodiments of the present application. Based on the embodiments of the present application, all other embodiments obtained by those skilled in the art without inventive effort shall fall within the scope of the present application.

It should be noted that all directional indications in the embodiments of the present application (such as up, down, left, right, front, back, etc.) are only used to explain the relative position relationship, movement status, etc. between the various components under a certain specific posture (as shown in the figures). If the specific posture changes, the directional indication will also change accordingly.

In addition, in the embodiments of the present application, descriptions such as "first" and "second" are only for descriptive purposes and should not be understood as indicating or implying their relative importance or implicitly indicating the number of the indicated technical features. Therefore, features defined as "first" and "second" may explicitly or implicitly include at least one of such features. In the description of the embodiments of the present application, the meaning of "plurality" is at least two, for example, two, three, etc., unless otherwise clearly and specifically defined.

In the embodiments of the present application, unless otherwise specified or limited, the terms "connection" and "fixation" should be understood in a broad sense. For example, "fixation" can mean a fixed connection, a detachable connection, or an integral connection; it can be a mechanical connection or an electrical connection; it can be a direct connection or an indirect connection through an intermediate medium; it can be the internal connection between two elements or the interaction between two elements, unless otherwise specified. For those skilled in the art, the specific meanings of the above terms in the embodiments of the present application can be understood according to the specific circumstances.

In addition, the technical solutions among the various embodiments of the present application can be combined with each other, but it must be based on the fact that those skilled in the art can implement them. When the combination of technical solutions is mutually contradictory or cannot be implemented, it should be deemed that such a combination of technical solutions does not exist and is not within the scope of the present application.

In network service systems, as the system speed increases, the operating voltage decreases while the operating current increases. Therefore, PCB power supply becomes increasingly important in high-speed system design. Chips must maintain voltage fluctuations within a certain range to ensure the proper functioning of various functions.

With the increase in the operating current of the chip, the design of high-current flow faces the following challenges: a voltage regulator module (VRM) requires stronger current output capability; a power delivery network (PDN) requires extremely low alternating current (AC) impedance and direct current (DC) resistance; and PCB power consumption control and power supply efficiency control.

In the case of relatively large currents, such as 1000A, a multi-phase VRM is required to simultaneously provide the required current. The existing power supply method is to provide sufficient output current through the VRM, and connect a plurality of inner power planes of the circuit board through vias to provide the required current to the chip. The disadvantage of this design is that it requires the design of multiple power planes of loz or 2oz, that is, solving the problem of large current flow by increasing the number of layers of PCB, which is relatively costly, and the DC resistance of the plane is large, making it difficult to meet the voltage drop requirements. If the chip end voltage does not meet the requirements, the VRM voltage needs to be increased, which affects the power supply efficiency and increases heat dissipation.

In view of this, the embodiment of the present application provides a printed circuit board, directly opens a window in the first power region of the surface power layer and surfaces a first current flow bridge. The first current flow bridge covers and extends to the outside of the first power region, making full use of the space without wiring in the surface power layer. Without increasing the thickness and number of layers of the PCB, the current area is effectively increased, so that the first power region can carry or transmit a larger current, reducing the plane resistance and current density, and reducing the voltage drop of the PDN. This improves the overall performance of the PCB, meets the use requirements of the PCB to transmit large currents, and helps to improve the high-current power supply efficiency of the PCB.

To better understand the above technical solution, the above technical solution is described in detail below with reference to the accompanying drawings.

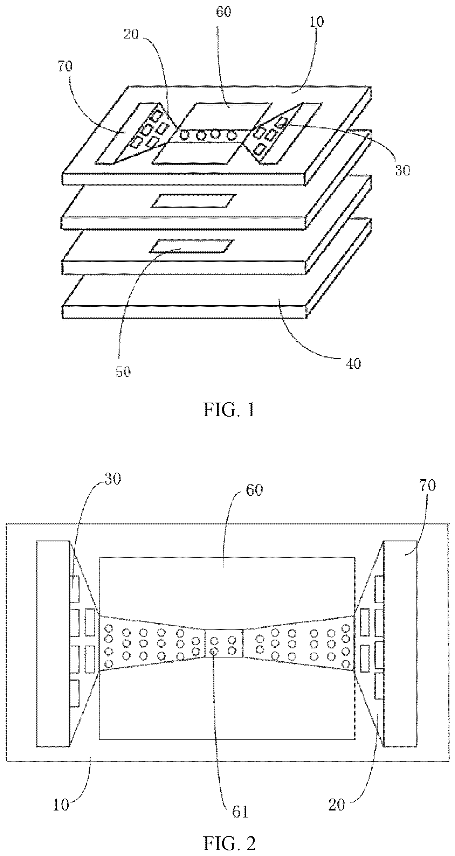

As shown in FIG. 1 to FIG. 3, an embodiment of the present application provides a printed circuit board for soldering a chip 60. The printed circuit board includes a surface power layer 10 and a first current flow bridge 20.

The surface power layer 10 has a first power region, and the first power region is configured for soldering pins 61 of the chip 60.

The first current flow bridge 20 is provided at the surface power layer 10 and is electrically connected to the first power region. The first current flow bridge 20 covers the first power region and extends to the outside of the first power region.

In the technical solution of this embodiment, by the first current flow bridge 20 provided at the surface power layer 10, the current flow area of the first power region can be increased, and the current flow performance of the first power region can be improved, so that the first power region can carry or transmit a larger current, reduce the plane resistance and current density, and reduce the voltage drop of the PDN, thereby improving the overall performance of the PCB, meeting the use requirements of the PCB for transmitting large currents, and helping to improve the large current power supply efficiency of the PCB. Moreover, in the structure for improving PCB current flow proposed in the present application, the window is provided in the first power region of the surface power layer 10 and surfaces the first current flow bridge 20, and the first current flow bridge 20 covers and extends to the outside of the first power region, which makes full use of the space without wiring in the surface power layer 10, and effectively increases the current flow area without increasing the thickness and number of layers of the PCB.

The printed circuit board includes the surface power layer 10. A single surface power layer 10 can be provided, or one or more inner signal layers 40 may be stacked on top of the surface power layer 10. The surface power layer 10 and the inner signal layer 40 are primarily used for wiring design and mounting electronic components. The surface power layer 10 has the first power region, and the inner signal layer 40 has a second power region. The first power region is connected to the second power region through a via. The second power regions of a plurality of inner signal layers 40 may also be connected through the vias. It can be understood that the first power region and the second power region are mainly used for power extraction and transmission, and play a role in current flow to supply power to the chip 60. As the operating current of the chip 60 increases, it is necessary to increase the current flow capacity of the first power region. To this end, the present application provides the first current flow bridge 20. The first current flow bridge 20 is a conductive structural member, which can be made of a conductive metal, such as copper. The shape of the conductive structural member can be a long strip, a sheet, etc., which is not limited here. It can be understood that the first current flow bridge 20 is electrically connected to the first power region, thereby increasing the current flow area of the first power region, improving the current flow capacity, and meeting the requirements of large current transmission. Moreover, the first current flow bridge 20 in the present application is connected to the first power region through a surface mount process. On the basis of covering the first power region, the first current flow bridge 20 extends to the outside of the first power region, which can further increase the current flow area. In addition, the first current flow bridge 20 in the present application fully utilizes the idle space without wiring in the surface power layer 10, which replaces the method of increasing the current flow area by adding circuit board layers, effectively reducing the planar DC resistance and the overall thickness of the circuit board, and improving the power supply efficiency. It should be pointed out that the first current flow bridge 20 in the present application completely covers the first power region, that is, the first current flow bridge 20 fully covers the entire first power region. Since the first current flow region is configured for soldering the pins 61 of the chip 60, that is, the first current flow region corresponds to the arrangement region of the pins 61, the first current flow bridge 20 in the present application corresponds to the arrangement region of the pins 61, that is, covering the arrangement region of the pins 61, to achieve better current flow with the chip 60.

For example, referring to FIG. 1 to FIG. 3, in an embodiment of the present application, the printed circuit board further includes a current flow block 30, and the current flow block 30 is provided on the first current flow bridge 20.

The current flow block 30 is electrically connected to the first current flow bridge 20. The provision of the current flow block 30 can increase the current flow area of the first current flow bridge 20, which improves the current flow capacity of the first current flow bridge 20, thereby improving the power supply performance of the entire printed circuit board. In an embodiment, the current flow block 30 is a cube and can have dimensions of 3mm*6mm*0.8mm or 3mm*4.5mm*3mm, or other dimensions can be selected based on actual usage requirements, which are not limited here. In another embodiment, the current flow block 30 can be made of copper or a copper alloy to ensure current flow performance. In an embodiment, the current flow block 30 and the first current flow bridge 20 are welded. It can be understood that the current flow block 30 is attached to the surface of the first current flow bridge 20, so that the edge or the entire current flow block 30 is fixed to the first current flow bridge 20. By welding, on the one hand, the firmness of the connection between the current flow block 30 and the first current flow bridge 20 can be improved, and on the other hand, the current flow block 30 and the first current flow bridge 20 can be electrically connected to form an integral conductive structure, thereby increasing the current flow area.

For example, in an embodiment of the present application, a plurality of current flow blocks 30 are provided and spaced apart.

Two or more current flow blocks 30 are provided at the first current flow bridge 20. The placement of these two or more through-flow blocks 30 can be determined based on the size of the first current flow bridge 20 and/or the location of current hotspots. That is, current flow blocks 30 are placed at the current hotspots to improve the current flow capacity at these locations and reduce production costs when the through-flow blocks 30 are placed across the entire region.

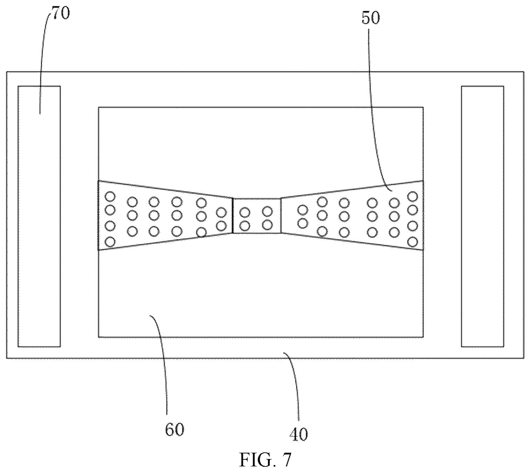

For example, referring to FIG. 1 and FIG. 4 to FIG. 7, in an embodiment of the present application, the printed circuit board further includes an inner signal layer 40, the inner signal layer 40 has a second power region, and the inner signal layer 40 is stacked with the surface power layer 10. The inner signal layer 40 is provided with a second current flow bridge 50, and the second current flow bridge 50 is electrically connected to the second power region and covers the second power region.

The printed circuit board further includes the inner signal layer 40 stacked with the surface power layer 10. To improve the current flow capacity of the inner signal layer 40, a second current flow bridge 50 is provided in the second power region of the inner signal layer 40. It can be understood that by providing the window in the inner signal layer 40 and providing the second current flow bridge 50 in the second power region through a surface mount process, the current flow area of the second power region can be increased, thereby improving the current flow performance of the entire printed circuit board and meeting current flow requirements of the high current. Moreover, in an embodiment, the second power region corresponds to the arrangement region of the pins 61 of the chip 60, that is, the second current flow bridge 50 completely covers the arrangement region of the pins 61 of the chip 60. The second current flow bridge 50 is a conductive structural member, which can be made of a conductive metal, such as copper. The shape of the conductive structural member can be a bar or strip, which is not limited here. The second current flow bridge 50 in the present application fully utilizes the idle space without wiring in the inner signal layer 40, which replaces the method of increasing the current flow area by adding circuit board layers. This effectively reduces the planar DC resistance and the overall thickness of the circuit board, thereby improving power supply efficiency.

For example, in an embodiment of the present application, at least two inner signal layers 40 are stacked, each of which is provided with the second current flow bridge 50. This increases the current flow area of each inner signal layer 40, thereby improving the current flow performance of the entire circuit board.

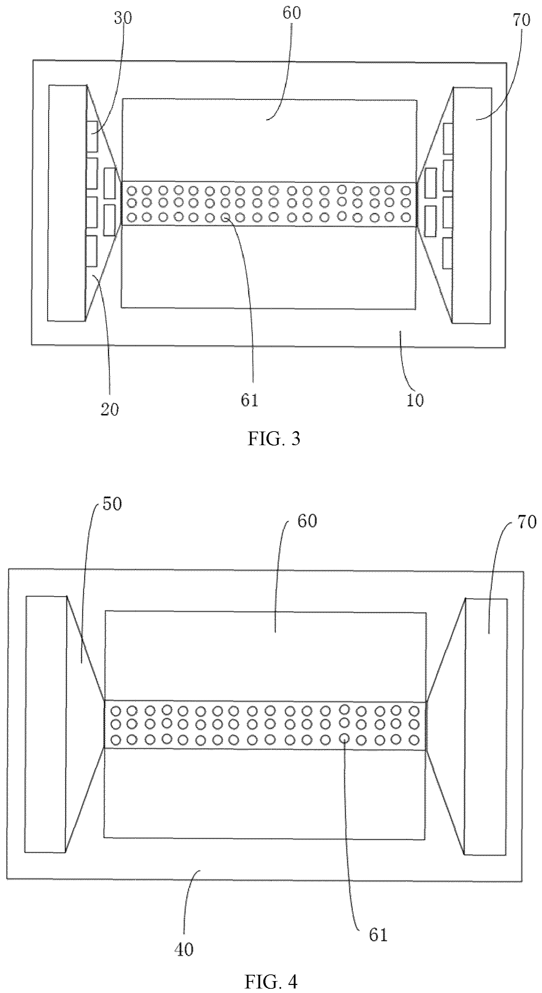

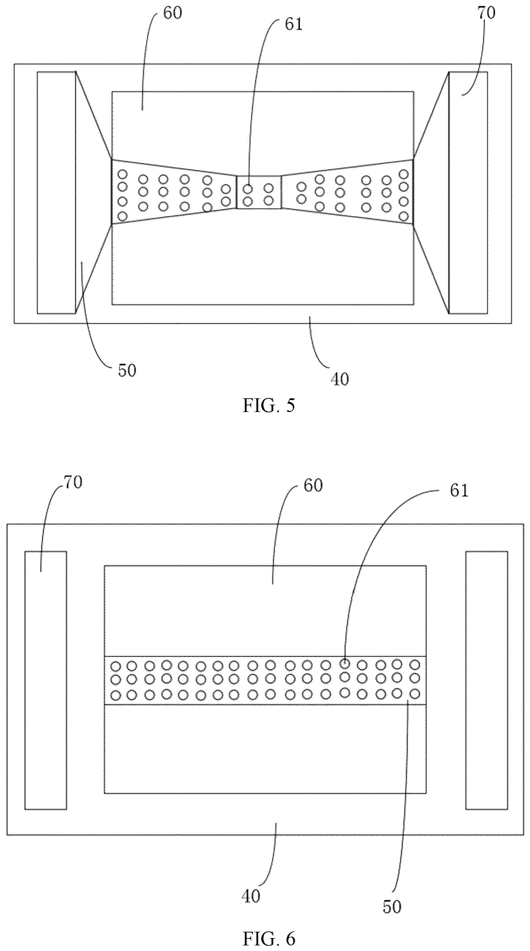

For example, referring to FIG. 4 and FIG. 5, in an embodiment of the present application, the second current flow bridge 50 extends to the outside the second power region. The second current flow bridge 50 may only cover the second power region. If there is sufficient space within the inner signal layer 40, the second current flow bridge 50 may also extend to the outside the second power region, further increasing the current flow area and improving the current flow performance.

For example, in an embodiment of the present application, the inner signal layer 40 is further provided with a thickened current flow coating, and the second current flow bridge 50 covers the thickened current flow coating.

When the current flow is limited, the thickened current flow coating can be provided at the second power region of the inner signal layer 40. With the thickened current flow coating, it is possible to increase the thickness of the second power region of the inner signal layer 40, thereby increasing the current flow area by increasing the thickness. The second current flow bridge 50 covers the thickened current flow coating, and the two work together to improve the current flow performance of the inner signal layer 40.

In the embodiments of the present application, a method for preparing the printed circuit board includes the following steps.

Step 1, Simulation: according to the system design requirements, simulating the power supply network of the printed circuit board. The simulation results indicate that the voltage drop requirements of the system design cannot be met or that the number of power supply layers needs to be further reduced.

Step 2, adjusting the arrangement of the pins of the chip so that the arrangement region extends to opposite ends of the chip.

Step 3, designing the first current flow bridge: designing the first current flow bridge on the surface power layer of the printed circuit board and providing the window.

Step 4: designing the second current flow bridge, designing the second current flow bridge on the inner signal layer of the PCB, and providing the thickened current flow coating at the second power region of the inner signal layer.

Step 5, designing the current flow blocks at the first current flow bridge. The number of current flow blocks to be added is determined according to the size of the first current flow bridge and the location of current hotspots.

Step 6: outputting the Gerber file in a universal format with a suffix recognizable to PCB manufacturers.

Step 7: surface mounting.

To achieve the above objectives, embodiments of the present application provide a power module including the printed circuit board described above, a chip 60 and a power supply module 70.

The chip 60 is provided at the first power region.

The power supply module 70 is provided on one side of the chip 60, and the first current flow bridge 20 extends to the power supply module 70.

The specific structure of the PCB refers to the above embodiments. Since the power module adopts all the technical solutions of the above embodiments, it has at least all the beneficial effects brought by the technical solutions of the above embodiments.

In an embodiment, the power module includes the printed circuit board, the chip 60 and the power supply module 70. The PCB is used for wiring design and mounting electronic components, and the chip 60 and the power supply module 70 are assembled on the PCB. The power supply module 70 can provide sufficient output current, utilizing the first power region and first current flow bridge 20 of the surface signal layer to provide the required current to the chip 60. This effectively utilizes the space in the surface power layer 10, increasing the effective current flow area without increasing the PCB thickness or number of layers, reducing the planar resistance and current density, and helping reduce the voltage drop in the power supply network. This improves the power supply performance and ensures the normal operation of the chip 60.

In another embodiment, two power modules 70 are provided and located on opposite sides of the chip 60. This allows the two power modules 70 to jointly provide output current, ensuring stable and reliable current supply. In an embodiment, the first current flow bridge 20 extends between the two power supply modules 70.

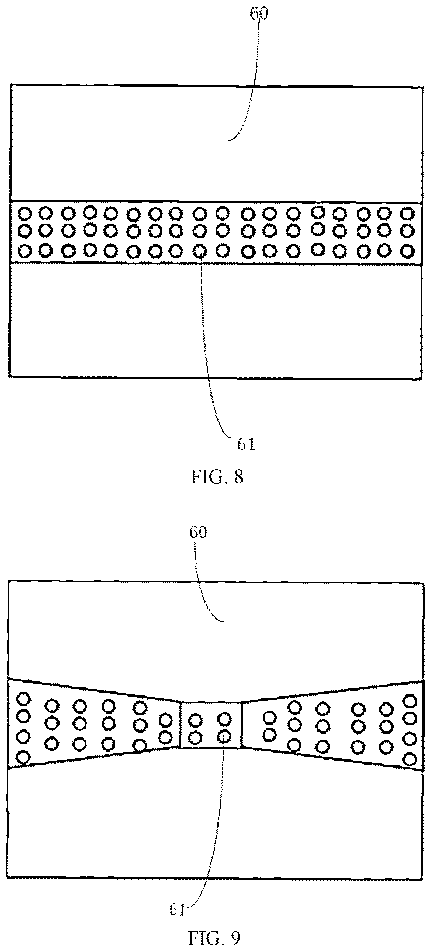

For example, referring to FIG. 8 and FIG. 9, in an embodiment of the present application, the chip 60 has a plurality of pins 61, which are dispersedly arranged to form an arrangement region that extends to opposite ends of the chip 60.

The chip 60 draws power from the printed circuit board through the pins 61. Under normal circumstances, the pins 61 are concentrated in the middle of the chip 60, which is not conducive to the arrangement of the first current flow bridge 20 or the second current flow bridge 50. To this end, the present application adjusts the arrangement of the pins 61 of the chip 60 based on the requirements of signal routing and power supply laying, that is, the pins 61 are no longer concentrated in the middle of the chip 60, but extend to the opposite ends of the chip 60. It can be understood that the pins 61 can be arranged horizontally or longitudinally, and it is only necessary to ensure that the area of the arrangement region after adjustment is equal to the area of the arrangement region before adjustment. In an embodiment, the arrangement region of the pins 61 is rectangular, refer to FIG. 8. In other embodiments, the width of the arrangement region increases from the middle to the ends, as shown in FIG. 9. It can be understood that the two ends of the arrangement region are symmetrically arranged with respect to the middle.

To achieve the above objectives, the present application provides an electronic device including the power module described above. The specific structure of the power module refers to the above embodiments. Since the electronic device adopts all the technical solutions of the above embodiments, it has at least all the beneficial effects brought by the technical solutions of the above embodiments, which will not be described here.

Compared with the existing technology, in a technical solution proposed in the present application, by providing the first current flow bridge at the surface power layer, the current flow area of the first power region can be increased, and the current flow performance of the first power region can be improved, so that the first power region can carry or transmit a larger current, reduce the plane resistance and current density, and reduce the voltage drop of the PDN, thereby improving the overall performance of the PCB, meeting the use requirements of the PCB for transmitting large currents, and helping to improve the large current power supply efficiency of the PCB. Moreover, in the structure for improving PCB current flow proposed in the present application, the window is provided in the first power region of the surface power layer and surfaces the first current flow bridge. The first current flow bridge covers and extends to the outside of the first power region, making full use of the space without wiring in the surface power layer, and effectively increasing the current flow area without increasing the thickness and number of layers of the PCB.

The above descriptions are merely some embodiments of the present application and do not limit the scope of the present application. All equivalent structural transformations made using the contents of the description and drawings of the embodiments of the present application under the inventive concept of the embodiments of the present application, or direct/indirect application in other related technical fields, are included in the scope of the embodiments of the present application.

## Claims

1. A printed circuit board for soldering a chip, **characterized by** comprising:
a surface power layer having a first power region, wherein the first power region is configured for soldering a pin of the chip; and
a first current flow bridge provided at the surface power layer and electrically connected to the first power region, wherein the first current flow bridge covers the first power region and extends to outside of the first power region.

2. The printed circuit board according to claim 1, further comprising a current flow block, wherein the current flow block is provided at the first current flow bridge.

3. The printed circuit board according to claim 2, further comprising a plurality of the current flow blocks spaced apart.

4. The printed circuit board according to claim 1, further comprising an inner signal layer, wherein the inner signal layer has a second power region, and the inner signal layer is stacked with the surface power layer; the inner signal layer is provided with a second current flow bridge, and the second current flow bridge is electrically connected to the second power region and covers the second power region.

5. The printed circuit board according to claim 4, wherein the second current flow bridge extends to outside of the second power region.

6. The printed circuit board according to claim 5, wherein at least two inner signal layers are stacked, and each of the at least two inner signal layers is provided with the second current flow bridge.

7. The printed circuit board according to claim 4, wherein the inner signal layer is further provided with a thickened current flow coating, and the second current flow bridge covers the thickened current flow coating.

8. A power module, **characterized by** comprising:
the printed circuit board according to any one of claims 1 to 7;
a chip provided in a first power region; and
a power supply module provided on one side of the chip, wherein a first current flow bridge extends to the power supply module.

9. The power module according to claim 8, wherein the chip has a plurality of pins, the plurality of pins are dispersedly arranged to form an arrangement region, and the arrangement region extends to opposite ends of the chip.

10. The power module according to claim 9, wherein the arrangement region is rectangular.

11. The power module according to claim 9, wherein the arrangement region has a width increasing from a middle to the opposite ends.

12. The power module according to any one of claims 8 to 11, wherein two power supply modules are provided on opposite sides of the chip.

13. An electronic device, **characterized by** comprising the power module according to any one of claims 8 to 12.
